(19) Europäisches Patentamt
European Patent Office
Office européen des brevets

(11) **EP 2 426 084 B1**

(12) **EUROPÄISCHE PATENTSCHRIFT**

(45) Veröffentlichungstag und Bekanntmachung des Hinweises auf die Patenterteilung:
**20.03.2013 Patentblatt 2013/12**

(21) Anmeldenummer: **11178308.0**

(22) Anmeldetag: **22.08.2011**

(51) Int Cl.:
*C01B 33/02* [(2006.01)]        *C01B 33/035* [(2006.01)]
*C30B 13/00* [(2006.01)]        *C30B 15/00* [(2006.01)]
*C30B 29/06* [(2006.01)]

(54) **Verfahren zur Herstellung von polykristallinem Silicium**

Process for production of polycrystalline silicon

Procédé de fabrication de silicium polycristallin

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.09.2010 DE 102010040093**

(43) Veröffentlichungstag der Anmeldung:
**07.03.2012 Patentblatt 2012/10**

(73) Patentinhaber: **Wacker Chemie AG**
**81737 München (DE)**

(72) Erfinder:
• **Schäfer, Dr. Marcus**
**83278 Traunstein (DE)**
• **Krätzschmar, Dr. Oliver**
**84508 Burgkirchen (DE)**

(74) Vertreter: **Killinger, Andreas et al**
**Wacker Chemie AG**
**Intellectual Property**
**Hanns-Seidel-Platz 4**
**81737 München (DE)**

(56) Entgegenhaltungen:
**EP-A1- 1 223 146        EP-A2- 2 067 744**
**JP-A- 2003 128 492        US-A- 4 148 931**

## Beschreibung

Polykristallines Silicium (kurz: Polysilicium) dient als Ausgangsmaterial bei der Herstellung von einkristallinem Silicium mittels Tiegelziehen (Czochralski- oder CZ-Verfahren)-oder mittels Zonenschmelzen (Floatzone oder FZ-Verfahren). Dieses einkristalline Silicium wird in Scheiben (Wafer) zertrennt und nach einer Vielzahl von mechanischen, chemischen und chemo-mechanischen Bearbeitungen in der Halbleiterindustrie zur Fertigung von elektronischen Bauelementen (Chips) verwendet.

Insbesondere wird aber polykristallines Silicium in verstärktem Maße zur Herstellung von ein- oder multikristallinem Silicium mittels Zieh- oder Gieß-Verfahren benötigt, wobei dieses ein-oder multikristalline Silicium zur Fertigung von Solarzellen für die Photovoltaik dient.

Das polykristalline Silicium wird üblicherweise mittels des Siemens-Prozesses hergestellt. Dabei werden in einem glockenförmigen Reaktor ("Siemens-Reaktor") dünne Filamentstäbe ("Dünnstäbe") aus Silicium durch direkten Stromdurchgang erhitzt und ein Reaktionsgas enthaltend eine Silicium enthaltende Komponente und Wasserstoff eingeleitet.

Die Silicium enthaltende Komponente des Reaktionsgases ist in der Regel Monosilan oder ein Halogensilan der allgemeinen Zusammensetzung $SiH_nX_{4-n}$ (n=0, 1, 2, 3; X = Cl, Br, I). Bevorzugt handelt es sich um ein Chlorsilan oder Chlorsilangemisch, besonders bevorzugt um Trichlorsilan. Überwiegend wird $SiH_4$ oder $SiHCl_3$ (Trichlorsilan, TCS) im Gemisch mit Wasserstoff eingesetzt.

In EP 2 077 252 A2 wird der typische Aufbau eines in der Herstellung von Polysilicium zum Einsatz kommenden Reaktortyps beschrieben.

Der Reaktorboden ist mit Elektroden versehen, die die Dünnstäbe aufnehmen, auf denen während des Wachstumsprozesses Silicium abgeschieden wird, die also zu den gewünschten Stäben aus Polysilicium wachsen. Üblicherweise werden jeweils zwei Dünnstäbe mit einer Brücke zu einem Dünnstabpaar verbunden, das über die Elektroden und über externe Vorrichtungen einen Stromkreis bilden, was dazu dient, die Stabpaare auf eine bestimmte Temperatur zu heizen.

Die Messung der Stabtemperatur erfolgt üblicherweise mit Strahlungspyrometern an den Oberflächen der senkrechten Stäbe.

Die Stabtemperatur wird üblicherweise durch Regelung der elektrischen Leistung entweder fest oder auch in Abhängigkeit vom Stabdurchmesser vorgegeben.

Ferner ist der Reaktorboden zusätzlich mit Düsen versehen, die den Reaktor mit frischem Gas versorgen. Das Abgas wird über Öffnungen wieder aus dem Reaktionsraum geführt.

Die zugeführte Menge an Reaktionsgasen wird üblicherweise in Abhängigkeit vom Stabdurchmesser variiert, d.h. in der Regel mit zunehmendem Stabdurchmesser erhöht.

An den erhitzten Stäben und der Brücke scheidet sich hochreines Polysilicium ab, wodurch der Stabdurchmesser mit der Zeit anwächst (CVD = Chemical Vapour Deposition /Gasphasenabscheidung).

Die erhaltenen Polysiliciumstäbe müssen nach Beendigung des Abscheidevorgangs zu Brocken und Chips verarbeitet werden, es sei denn sie sind für die Herstellung von Einkristallen nach dem FZ-Verfahren vorgesehen.

Im letzteren Fall werden aus den Polysiliciumstäben durch Zonenschmelzen monokristalline Silicium-Ingots erzeugt, die später zu Siliciumwafern weiterverarbeitet werden.

Um Siliciumbruch für CZ oder Solar zu erzeugen, werden die Stäbe mit Werkzeugen, wie Hämmern, Brechern oder Mühlen, mechanisch zerkleinert und anschließend nach Größe klassiert. Die Größe der Siliciumstücke reicht dabei von etwa 1 mm bis zu Stücken von 150 mm und mehr. Die Form der Stücke sollte üblicherweise nicht zu stark von der Kugelform abweichen.

Alle bekannten Verfahren zur Abscheidung von Polysilicium, die auf dem Siemens-Prozess basieren, weisen Nachteile hinsichtlich der erreichten Produktqualität und der Wirtschaftlichkeit des Herstellungsprozesses auf.

Als Nachteile bezüglich der Produktqualität sind insbesondere zu nennen eine oft beobachtete axiale Variation des Stabdurchmessers, sowie eine teils schlechte Oberflächenbeschaffenheit der Stäbe.

Oftmals ist bei den Prozessen ein erhöhter Energiebedarf vonnöten.

Teilweise kommt es zu einem Umfallen von Stäben im Reaktor.

Schließlich bildet sich bei manchen Prozessen Siliciumstaub.

In manchen Prozessen kommt es zu einer Überhitzung und schlimmstenfalls sogar zu einem Schmelzen des Silicium-Trägerkörpers (Stäbe und Brücke).

In DE 29 12 661 A1 wird ein Verfahren zur Produktion von polykristallinem Silicium dargestellt, bei dem mittels einer speziellen Düse (Zweistrahldüse) teilweise flüssiges Trichlorsilan in die Reaktorkammer eingebracht wird. Damit soll der Anteil von Trichlorsilan im Reaktionsgas erhöht und letztlich eine höhere Ausbringung erreicht werden. Hier hat sich aber gezeigt, dass der spezifische Energieverbrauch deutlich zu hoch ist.

In EP 2 077 252 A2 wird es prozesstechnisch als vorteilhaft angesehen, Düsen für die Reaktionsgasversorgung während des Abscheideprozesses zu- bzw. abzuschalten. Dazu wird der Anteil geschlossener Düsen in Abhängigkeit von Prozesszeit oder Stabdurchmesser geregelt.

Ziel dieser Maßnahme ist es, bei wachsendem Stabdurchmesser eine optimale Gasversorgung aller Stäbe - insbesondere im oberen Bereich - sicherzustellen.

In EP 2 067 744 A2 wird ein Herstellungsverfahren für polykristallines Silicium offenbart, bei dem die Einströmgeschwindigkeit des Reaktionsgases, durch das Silicium abgeschieden wird, nach einem ersten Stabilisierungsschritt zunächst stark und dann langsamer gesteigert wird, um die Versorgung der Dünnstäbe mit Reaktionsgas zu verbessern, und anschließend im Wachstumsschritt reduziert wird, um eine effiziente Abscheidung sicherzustellen. Es wird betont, dass nur die Versorgung mit Reaktionsgas geregelt wird und somit keinerlei Modifikationen an den Reaktoren erforderlich sind.

Allerdings zeigen die in EP 2 077 252 A2 und in EP 2 067 744 A2 beschriebenen Verfahren ein verstärktes Umfallen von Stäben. Dies hängt vermutlich mit den abrupten Änderungen der Einströmgeschwindigkeiten des Reaktionsgases zusammen.

Die Länge der verwendeten Dünnstäbe kann mehrere Meter betragen (üblich sind etwa 2-3 m). Stäbe können beim Umfallen auch andere benachbarte Stäbe umwerfen.

Dies verursacht einen beträchtlichen wirtschaftlichen Schaden, insbesondere wenn dabei kontaminierte Siliciumstäbe aufwändig gereinigt werden müssen oder gar der Reaktor beim Umfallen der Stäbe beschädigt wird.

Wenn dies vor Ende des Abscheideprozesses passiert, muss der Abscheidevorgang sofort abgebrochen werden, um die umgefallenen Stäbe zu bergen. Dies hat unmittelbare Auswirkungen auf die Wirtschaftlichkeit der entsprechenden Anlage. Der wirtschaftliche Schaden ist umso größer, je mehr Stäbe sich im Reaktor befinden. Andererseits ist eine hohe Wirtschaftlichkeit im Normalbetrieb direkt mit einer hohen Anzahl an Stäben im Reaktor gekoppelt.

Ein weiterer Nachteil des in EP 2 067 744 A2 offenbarten Verfahrens besteht darin, dass es offenbar unmöglich ist, eine konstante Geometrie bzw. Morphologie über die gesamte Stablänge und zugleich eine ausreichend hohe Abscheiderate zu erreichen.

Die Geometrie eines Siliciumstabes während des Abscheideprozesses entspricht idealerweise einem im Radius wachsenden Zylinder. Abweichungen von dieser Zylinderform können Störungen des Prozesses verursachen. Im ungünstigsten Fall können Stäbe zusammenwachsen und den Abscheidevorgang unterbrechen. Ergibt sich bzgl. der genannten Abweichung eine sich nach unten verjüngende Kegelform, erhöht sich wegen der ungünstigeren Gewichtsverteilung wiederum auch das Risiko für ein Umfallen der Stäbe.

Die Anforderungen an Stäbe aus Polysilicium, die später für das Floatzone-Verfahren verwendet werden sollen, sind besonders streng. Die Stäbe werden vor Verwendung auf einen Nenndurchmesser rund geschliffen. Jede Überschreitung des Zieldurchmessers bedeutet einen erhöhten Abtrag beim Rundschleifen und damit Verlust an kostbarem Silicium. Jede Unterschreitung des Zieldurchmessers vermindert andererseits die Länge des zu verwendenden Stabstückes und verschlechtert somit die Wirtschaftlichkeit des angestrebten Produkts.

Stäbe aus Polysilicium lassen sich neben Länge und Durchmesser auch mittels weiterer Parameter beschreiben: Die Oberfläche des Stabes kann unterschiedlich ausgeprägt sein. Eine Ausprägung kann durch eine dem Blumenkohl ähnliche Oberfläche gegeben sein. Der Stab kann aber auch eine weitgehend glatte Oberfläche aufweisen. Die gesamten Eigenschaften der Oberfläche des Stabs sollen nachfolgend mit dem Begriff "Morphologie" bezeichnet werden.

Es ist bekannt, dass in erster Linie eine hohe mittlere Abscheiderate für eine hohe Produktivität und damit für die Wirtschaftlichkeit des Prozesses maßgeblich ist. Daher ist man bestrebt, die Abscheiderate nach Möglichkeit zu maximieren. Allerdings erfordert eine höhere Abscheiderate aber meist Prozessbedingungen, die sich z.B. auf die Morphologie nachteilig auswirken.

In DE 102 007 047 210 A1 ist ein Verfahren offenbart, das zu Polysiliciumstäben mit vorteilhafter Biegefestigkeit führt. Ferner ist der spezifische Energieverbrauch bei diesem Verfahren besonders niedrig. Prozesstechnisch wird ein Maximalwert des Mengenstromes des Chlorsilan-Gemisches in weniger als 30 Stunden - bevorzugt in weniger als 5 Stunden - erreicht, wobei die Temperatur an der Unterseite der Brücke zwischen 1300 °C und 1413 °C beträgt.

Problematisch ist jedoch, dass die Temperatur im Inneren der Brücke höher sein kann als die nach DE 102 007 047 210 A1 zwischen 1300 °C und 1413 °C gehaltene Temperatur an der Brückenoberfläche.

Die Temperatur wird durch den elektrischen Strom in Stab und Brücke geregelt. Um bei Kühlung der Brückenoberfläche durch einströmendes Gas die Temperatur halten zu können, muss der elektrische Strom erhöht werden.

Halbleiter wie Silicium haben bekanntermaßen die Eigenschaft, dass ihr elektrischer Widerstand mit zunehmender Temperatur abnimmt.

Da die Temperatur im Inneren eines aufgeheizten Stabes höher ist als an dessen Oberfläche, die durch das Reaktionsgas gekühlt wird, ist der elektrische Widerstand im Inneren des Stabes und der Brücke niedriger. Damit ist der Stromfluss im Inneren der Brücke höher.

Im Grenzfall eines hohen thermischen Flusses infolge starker Abkühlung der Oberfläche der Brücke durch die Reaktionsgase kann dies zu einer Temperatur im Inneren der Brücke führen, die über der Schmelztemperatur von Silicium (1413°C) liegt. Dann kommt es zu einem sog. "Brückenauslaufen", was unweigerlich zu einer Unterbrechung des Abscheideprozesses führt.

Bei dem in DE 10 2007 047 210 A1 beschriebenen Prozess ist die Wahrscheinlichkeit für das Brückenauslaufen deutlich erhöht.

Dies könnte nur durch Reduktion der Brückentemperatur verhindert werden, was jedoch die Vorteile der vergleichsweise hohen Abscheiderate und der verbesserten Energieeffizienz wieder zunichte machen würde.

In DE 10 2007 023 041 A1 wird ein weiteres Verfahren zur Herstellung von Polysilicium und zwar für FZ (Float Zone)-Silicium beschrieben. Es sieht bis zu einem Stabdurchmesser von 30 mm eine Stabtemperatur von 950 bis 1090°C und einen bestimmten Anteil an Chlorsilanen im Reaktionsgas vor, und spätestens nach Erreichen eines Stabdurchmessers von 120 mm Umstellung der Stabtemperatur auf 930 bis 1030°C und Erhöhung des Anteils an Chlorsilanen im Reaktionsgas. Abrupte Änderungen der Wachstumsbedingungen während der gesamten Abscheidezeit dürfen nicht vorgenommen werden.

Stäbe aus Polysilicium, die zur Produktion von FZ-Silicium verwendet werden, werden nach der Abscheidung üblicherweise mittels mechanischer Bearbeitung auf den gewünschten Durchmesser gebracht. Um den Verlust an Silicium möglichst gering zu halten, sollten alle erzeugten Stäbe den gleichen Durchmesser über die gesamte Länge aufweisen. Außerdem sollte der Querschnitt der Stäbe über die gesamte Länge rund sein.

Allerdings zeigen die nach DE 10 2007 023 041 A1 hergestellten Stäbe aus Polysilicium eine ungenügende Geometriekonstanz bezüglich des Durchmessers als Funktion der Länge der Kristalle. Der Durchmesser variiert mit der Länge des Kristalls, was zur Folge hat, dass an einer Seite mehr Material abgetragen werden muss, um den Nenndurchmesser nach mechanischer Bearbeitung zu erhalten. Dies reduziert die Wirtschaftlichkeit des Prozesses.

Ein weiteres Problem, das im Stand der Technik oft auftritt, ist die Staubabscheidung.

Von Staubabscheidung spricht man dann, wenn sich das Silicium enthaltende Gas nicht an der Oberfläche der Stäbe abscheidet (heterogene Abscheidung), sondern im freien Volumen (homogene Abscheidung) zu Silicium reagiert.

Der so entstandene Staub findet sich am Ende des Abscheideprozesses zum einen am Boden des Reaktors wieder und muss später entsorgt werden.

Zum anderen wird er mit dem Abgas zur Abgasaufbereitung transportiert, wo er Störungen verursachen kann.

Starke Staubabscheidung kann zu einem Abbruch des Abscheideprozesses zwingen. Dadurch verringert sich die Wirtschaftlichkeit.

Ferner bedingt sie erhebliche Probleme in den technischen Anlagen und damit einhergehenden Mehraufwand.

Leider zeigt sich, dass gerade Abscheidungsprozesse mit besonders hoher Abscheiderate zu teils erhöhter Staubabscheidung neigen.

Insgesamt ergibt sich, dass es im Stand der Technik bislang nicht gelungen ist, die verschiedenen, bei der Abscheidung von Polysilicium wichtigen Aspekte in Einklang zubringen.

Aus dieser Problematik ergab sich die Aufgabenstellung der vorliegenden Erfindung.

Die Aufgabe der Erfindung wird gelöst durch ein Verfahren zur Herstellung von polykristallinem Silicium, umfassend Einleiten eines Reaktionsgases enthaltend eine Silicium enthaltende Komponente und Wasserstoff mittels einer oder mehreren Düsen in einen Reaktor enthaltend wenigstens einen erhitzten Filamentstab, auf dem Silicium abgeschieden wird, dadurch gekennzeichnet, dass eine Archimedes-Zahl $Ar_n$, die Strömungsverhältnisse im Reaktor beschreibt, in Abhängigkeit vom Füllgrad FG, der das Verhältnis von einem Stabvolumen zu einem Reaktorleerraumvolumen in Prozent angibt, für einen Füllgrad FG von bis zu 5% innerhalb des nach unten durch die Funktion $Ar = 2000 \times FG^{-0,6}$ und nach oben durch die Funktion $Ar = 17000 \times FG^{-0,9}$ begrenzten Bereichs liegt, und bei einem Füllgrad von größer als 5% in einem Bereich von mindestens 750 bis höchstens 4000 liegt.

Wesentlich für das Gelingen des Verfahrens ist es, den Prozess so zu führen, dass die Archimedes-Zahl, die die Strömungsverhältnisse im Reaktor als das Verhältnis von freier zu erzwungener Konvektion beschreibt, in einem definierten Bereich liegt. Dieser Bereich ist für die gesamte Prozessdauer definiert.

Dazu wird die Archimedes-Zahl in Abhängigkeit vom Füllgrad des Reaktors angegeben.

Der Füllgrad eines Reaktors gibt das Verhältnis des Volumens der Stäbe zum Leerraumvolumen des Reaktors in Prozent an. Das Leerraumvolumen des Reaktors ist konstant.

Der Füllgrad nimmt also mit zunehmender Prozessdauer zu, da sich das Volumen der Stäbe erhöht.

Besonders vorteilhaft ist, dass das Verfahren und der erfindungsgemäße Bereich für die Archimedes-Zahl unabhängig von der Größe des Reaktors sind. Damit ist das Verfahren sowohl für kleine als auch für größere Reaktortypen geeignet.

Das Verfahren ist ebenso unabhängig von der Zahl und auch von der Länge der Filamentstäbe, die sich im Reaktor befinden und an denen Silicium abgeschieden wird.

Die allgemeine Beschreibung von Strömungsverhältnissen in einem Behälter mittels der Archimedes-Zahl ist aus Lehrbüchern zur technischen Thermodynamik bekannt, z.B. Dittmann / Fischer /Huhn / Klinger, "Repetitorium der technischen Thermodydnamik", Teubner Verlag (1995).

Die Archimedes-Zahl ist auch unter dem Namen Richardson-Zahl bekannt.

Für Siemensreaktoren zu Abscheidung von polykristallinem Silicium wurden bezüglich der Archimedes-Zahl noch keine Betrachtungen angestellt.

Ein bei der Abscheidung von Silicium verwendeter Siemensreaktor kann als ein Behälter mit einem gewissen Volumen (Leerraumvolumen) angesehen werden, wobei das Volumen durch Wände mit einer bestimmten Temperatur $T_{Wand}$ begrenzt ist. Ferner beinhaltet dieser Raum mit der Zeit durch Abscheidung von Silicium wachsende Stäbe mit einer bestimmten Temperatur $T_{stab}$.

Gas wird an den heißen Stäben erwärmt und steigt nach oben. An den Wänden wird das Gas wieder abgekühlt und sinkt nach unten. Man spricht hierbei von freier Konvektion des Gases.

Zusätzlich wird in diesen Raum Reaktionsgas (Wasserstoff und Silicium enthaltende Gase, wie zum Beispiel eine Mischung aus Trichlorsilan und Dichlorsilan) aktiv durch - üblicherweise am Boden angebrachte - Düsen mit einer definierten Einströmgeschwindigkeit eingebracht. Dabei wird eine erzwungene Konvektion verursacht.

Gleichzeitig wird Abgas aus dem Behälter entnommen, wobei üblicherweise der Druck im Behälter konstant gehalten wird.

Die freie Konvektion führt zu einer Auftriebskraft, die erzwungene Konvektion zu einer Trägheitskraft. Es wurde gefunden, dass das Zusammenwirken dieser beiden Strömungskräfte offenbar die komplexen Strömungsverhältnisse und deren Auswirkungen auf die Abscheidung im Reaktor dominiert. Damit ist die Archimedes-Zahl, die als Verhältnis von Auftriebskraft zu Trägheitskraft definiert ist, zur Charakterisierung der Strömungsverhältnisse geeignet.

Auf die konkrete Herleitung der Archimedes-Zahl Ar für einen Stab in einem Siemensreaktor wird an dieser Stelle verzichtet.

Es ergibt sich folgender Zusammenhang:

$$Ar = \pi * g * L^3 * A_d * (T_{Stab} - T_{Wand}) / (2 * Q^2 * (T_{Stab} + T_{Wand}))$$

wobei g für die Erdbeschleunigung in m/s², L für die Stablänge der Filamentstäbe in m, Q für den Volumenstrom des Gases in m³/s unter Betriebsbedingungen (p, T), $A_d$ für die Summe aller Düsenquerschnittsflächen in m², $T_{stab}$ für die Stabtemperatur in K und $T_{Wand}$ für die Wandtemperatur in K stehen.

Die Länge der Filamentstäbe bleibt während der Abscheidung im Wesentlichen konstant, z.B. L = 3 m.

Umfasst der Reaktor zum Einbringen von Reaktionsgasen eine oder mehrere Düsen mit gleichen oder unterschiedlichen Querschnitten, wird die Summe aller Düsenquerschnitte $A_d$ (in m²) berücksichtigt.

Der Querschnitt einer oder mehrer Düsen kann auch zeitlich variabel sein.

Die Summe aller Querschnitte $A_d$ beträgt vorzugsweise mindestens 5 x $10^{-5}$ m² bis zu etwa 1 x $10^{-2}$ m².

Die Stabtemperatur beträgt vorzugsweise 1150K bis 1600K.

Die Wandtemperatur beträgt vorzugsweise 300K bis 700K.

Der Volumenstrom beträgt vorzugsweise 0,001 m³/s bis 0,5 m³/s bei Betriebsbedingungen.

Bei mehreren Filamentstäben in einem Reaktor wird die Archimedes-Zahl als Summe über die Anzahl n dieser Stäbe ermittelt. Es ergibt sich $Ar_n$.

Die Gleichung lautet dann:

$$Ar_n = n * Ar$$

Das erfindungsgemäße Verfahren ist jedoch - wie zuvor bereits erwähnt - unabhängig von der Zahl der Stäbe im Reaktor.

Die Erfinder haben erkannt, dass eine bloße Verdopplung des Volumenstroms an Reaktionsgasen bei einer Verdopplung der Zahl der Stäbe im Reaktor nicht zum Erfolg führt, da ein solcher Prozess einen Verlauf der Archimedes-Zahl in Abhängigkeit vom Füllgrad zeigt, der unterhalb des beanspruchten Bereichs liegt. Der Prozess weist zudem einen erhöhten spezifischen Energieverbrauch und zusätzlich einen erhöhten Anteil umgefallener Stäbe auf. Wird dagegen z.B. auch die Düsenkonfiguration angepasst, ist es möglich, geringere Anteile umgefallener Stäbe und einen geringeren spezifischen Energieverbrauch zu erreichen. Es hat sich gezeigt, dass ein optimaler Prozess für den Fall der Verdopplung der Anzahl der Stäbe wiederum Strömungsverhältnisse erfordert, die den im erfindungsgemäßen Verfahren beanspruchten entsprechen.

Es hat sich gezeigt, dass für alle Prozesse, deren Archimedeszahl für einen Füllgrad FG von bis zu 5% innerhalb des nach unten durch die Funktion Ar = $2000 \times FG^{-0,6}$ und nach oben durch die Funktion Ar = $17000 \times FG^{-0,9}$ begrenzten Bereichs liegt, und bei einem Füllgrad von größer als 5% in einem Bereich von mindestens 750 bis höchstens 4000 liegt, folgende vorteilhaften technischen Effekte gleichzeitig und reproduzierbar auftreten:

Es wird kaum Staubabscheidung beobachtet bei gleichen bzw. höheren mittleren Abscheideraten als im Stand der Technik.

Bei Durchführung des erfindungsgemäßen Verfahrens tritt kein Stab- und/oder Brückenauslaufen auf.

Die Messung der Stabtemperatur erfolgt im Rahmen der Erfindung mit Strahlungspyrometern an den Oberflächen der senkrechten Stäbe und zwar bevorzugt an der Seite des Stabes, die der Außenwand des Reaktors am nächsten steht, in halber Höhe des Stabes. Die Oberflächentemperatur wird also in der Mitte des Stabes geregelt. Daher wird in Verbindung mit den optimalen Strömungsbedingungen im gesamten Reaktor ein Auslaufen der Brücke vermieden.

Es hat sich gezeigt, dass der Anteil umgefallener Stäbe bei diesen Prozessen wesentlich niedriger als bei den aus dem Stand der Technik bekannten Prozessen.

Alle polykristallinen Stäbe, die mit erfindungsgemäßen Prozessen erzeugt wurden, wiesen eine gegenüber dem Stand der Technik geringere Durchmesservariation über die Stablänge auf.

Außerdem hat sich gezeigt, dass die Morphologie von Siliciumstäben beim erfindungsgemäßen Verfahren einerseits unabhängig von der axialen Position am Stab und andererseits aber auch unabhängig von der Position des Stabes in der Abscheideanlage ist, also alle Stäbe unabhängig von der Position eine solche vorteilhafte Morphologie aufweisen.

Im Folgenden wird die Erfindung anhand einer Figur erläutert.

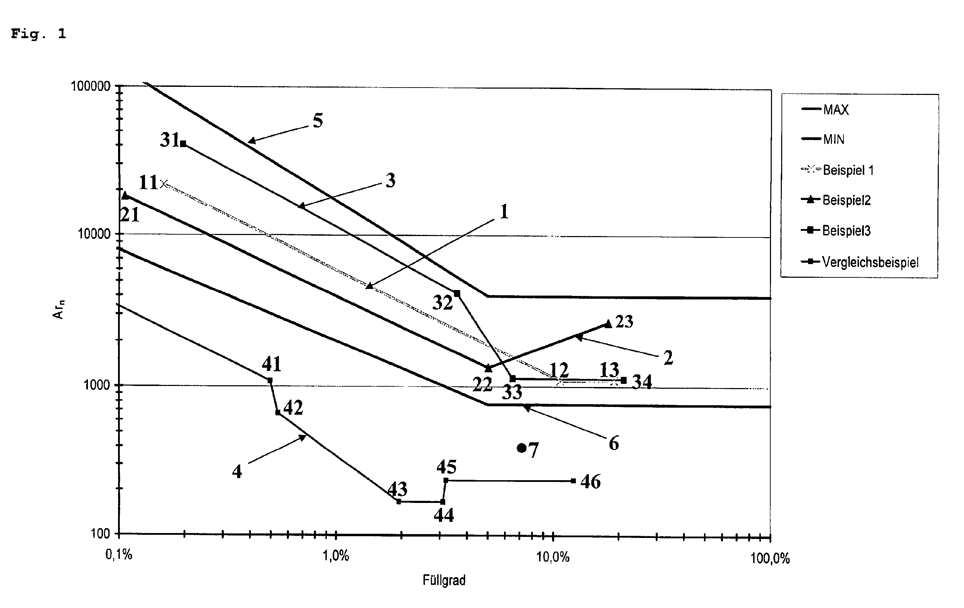

**Fig. 1** zeigt den erfindungsgemäßen Bereich für die Archimedes-Zahl in Abhängigkeit vom Füllgrad und drei Beispielprozesse, sowie ein Vergleichsbeispiel.

In **Fig. 1** wird der erfindungsgemäße Bereich für die Archimedes-Zahl in Abhängigkeit vom Füllgrad gezeigt. Die Kurven sind doppelt-logarithmisch dargestellt.

Der erfindungsgemäße Bereich wird durch die Linien **5** und **6** begrenzt, die den maximal und minimal erlaubten Verlauf der Archimedes-Zahl angeben. Dabei handelt es sich bis FG = 5% um Exponentialfunktionen.

Die Steigung der beiden Kurven **5** und **6** bis FG = 5% ist in doppelt-logarithmischer Darstellung unterschiedlich. Dementsprechend weisen die beiden Exponentialfunktionen unterschiedliche Exponenten auf.

Es zeigt sich, dass die Kurve für einen einzelnen Prozess bis FG = 5% fallen muss, um nicht für FG > 5% den erlaubten Bereich für die Archimedes-Zahl zu verlassen.

Alle untersuchten Prozesse zeigen zumindest bis FG = 5% einen fallenden Verlauf, wobei sie sich bei höheren Füllgraden unterschiedlich verhalten.

Die Kurven **1, 2** und **3** zeigen drei typische Verläufe der Archimedes-Zahl. Die Kurven **1, 2** und **3** werden später anhand der Beispiele 1-3 näher beschrieben.

Bei den Kurven **1** und **2** ist zu erkennen, dass die Archimedes-Zahl zunächst kontinuierlich abnimmt. Dies gilt zumindest bis zu einem Füllgrad von 5% wie bei Kurve **2,** kann sich aber auch bis zu einem höheren Füllgrad, wie z.B. bis zu einem Füllgrad von etwa 10% wie in Kurve **1,** fortsetzen.

Bei Kurve **1** verläuft die Archimedes-Zahl anschließend konstant.

Bei Kurve **2** zeigt sich ein ganz anderer Verlauf. Die Archimedes-Zahl steigt ab FG = 5% wieder an. Da in **Fig. 1** die doppelt-logarithmische Darstellung gewählt ist, handelt es sich dabei wiederum um eine Exponentialfunktion.

Bei Kurve **3** nimmt die Archimedes-Zahl bis zu einem Füllgrad von ca. 7% ab. Zwischen einem Füllgrad von ca. 4% und ca. 7% fällt die Archimedes-Zahl stärker als für einen Füllgrad von weniger als ca. 4%. Damit handelt sich beim Verlauf der Archimedes-Zahl bis ca. 4% Füllgrad um eine Exponentialfunktion mit einem Exponenten $x_1$ und beim Verlauf der Archimedes-Zahl zwischen ca. 4% und 7% ebenfalls um eine Exponentialfunktion mit einem Exponenten $x_2$, wobei $x_2 < x_1$. Ab einem Füllgrad von größer als ca. 7% bleibt die Archimedes-Zahl dann konstant.

Es zeigt sich also, dass der Verlauf der Archimedes-Zahl in Abhängigkeit vom Füllgrad durchaus unterschiedlich sein kann. Die Archimedes-Zahl kann zunächst fallen und dann weitgehend konstant bleiben oder auch wieder ansteigen.

Erfindungswesentlich ist, dass die Archimedes-Zahlen für keinen Füllgrad den durch die Kurven 5 und 6 definierten Bereich verlassen.

Die Erfinder haben erkannt, dass alle Prozesse, deren Archimedes-Zahl sich außerhalb des beschriebenen Bereichs befindet, mit erheblichen, bereits im Stand der Technik bekannten Nachteilen einhergehen.

**Vergleichsbeispiel**

Kurve **4** zeigt die Archimedes-Zahl in Abhängigkeit vom Füllgrad für den aus EP 2 067 744 A2 bekannten Prozess.

Dabei wurden für alle zu Ermittlung der Archimedes-Zahl benötigten und in der Anmeldung nicht offenbarten Parameter übliche Werte angenommen oder berechnet. Die Düsenfläche wurde aus den Geschwindigkeitsangaben und dem Anteil geschlossener Düsen berechnet.

Die Ergebnisse sind in **Tabelle 1** dargestellt.

Die Punkte **41, 42, 43, 44, 45** und **46** sind in **Fig. 1** dargestellt.

**Tabelle 1**

| Reaktorvolumen [m$^3$] | Stabanzahl | Stablänge [m] | $T_{Wand}$ [K] | $T_{Stab}$ [K] |
|---|---|---|---|---|
| 17 | 98 | 1,9 | 393 | 1273 |
| | | | | |
| | FG [%] | Q [m$^3$/s] | $A_d$ [m$^2$] | $Ar_n$ |
| | 0,03 | 0,047 | 3,14E-03 | 7740 |
| **Fig.1 - 41** | 0,50 | 0,126 | 3,14E-03 | 1088 |
| **Fig.1 - 42** | 0,54 | 0, 137 | 2,28E-03 | 667 |
| **Fig.1 - 43** | 1,94 | 0,273 | 2,28E-03 | 167 |
| **Fig.1 - 44** | 3,10 | 0,273 | 2,28E-03 | 167 |
| **Fig.1 - 45** | 3,21 | 0,261 | 2, 90E-03 | 233 |
| **Fig.1 - 46** | 12,41 | 0,261 | 2, 90E-03 | 233 |

Der Verlauf der Archimedes-Zahl für den Prozess aus EP 2 067 744 A2 liegt deutlich unterhalb des erfindungsgemäßen Bereichs für die Archimedes-Zahl und zeigt eine ganz andere Charakteristik, die auf die Änderungen der Einströmgeschwindigkeiten des Reaktionsgases zurückzuführen sein dürften.

Hier zeigt sich insbesondere ein erhöhter Anteil umgefallener Stäbe. Auch ist die Abscheiderate nur dann ausreichend hoch, wenn eine ungleichmäßigere Morphologie in Kauf genommen wird. Die Tatsache, dass durch eine Erhöhung der Archimedes-Zahl diese Probleme beseitigt werden konnten, ist überraschend.

Auch der in DE 29 12 661 A1 beschriebene Prozess zeigt einen Verlauf der Archimedes-Zahl in Abhängigkeit vom Füllgrad, der unterhalb des erfindungsgemäßen Bereichs liegt (ähnlich dem Prozess aus EP 2 067 744 A2, jedoch ohne dessen speziellen Verlauf). In diesem Prozess kommt eine Zweistrahldüse zum

Einsatz. Dabei wurden nachfolgende offengelegte Parameter verwendet:

**Tabelle 2**

| Reaktorvolumen [m$^3$] | Stabanzahl | Stablänge [m] | $T_{Wand}$ [K] | $T_{Stab}$ [K] |
|---|---|---|---|---|
| 3 | 8 | 2 | 393 | 1373 |
| | | | | |
| | FG [%] | Q [m$^3$/s] | $A_d$ [m$^2$] | $Ar_n$ |
| **Fig. 1 - 7** | 6,89 | 0,0101 | 6, 79E-05 | 364 |
| | | | | |

Der Punkt **7** ist in **Fig. 1** dargestellt.

Der in DE 29 12 661 A1 beschriebene Vorteil hinsichtlich der Gleichmäßigkeit der Stabgeometrie kann zwar bei einem solchen Prozess beobachtet werden jedoch zeigt dieser Prozess andere erhebliche Nachteile.

So ist der spezifische Energieverbrauch deutlich höher als bei Prozessen, die bezüglich der Archimedes-Zahl im erfindungsgemäßen Bereich liegen.

Die erfindungsgemäßen Prozesse weisen demgegenüber einen um 10-20 % geringeren spezifischen Energieverbrauch auf.

Außerdem zeigt der Prozess ebenfalls einen deutlich erhöhten Anteil umgefallener Stäbe.

Der Anteil umgefallener Stäbe ist bei den Prozessen nach DE 29 12 661 A1 sowie nach EP 2 067 744 A2 um etwa 50-100 % höher als bei erfindungsgemäßen Prozessen, die einen Verlauf der Archimedeszahl innerhalb des erfindungsgemäßen Bereichs aufweisen.

**Beispiele**

Es werden drei verschiedene erfindungsgemäße Prozesse dargestellt.

Dabei kamen unterschiedliche Reaktoren zum Einsatz, die sich bezüglich Reaktorvolumen und Zahl der Stäbe unterschieden.

Bei einem der Prozesse (Beispiel 1) kam ein Reaktor mit 48 Stäben und einem Reaktorvolumen von 12,7 $m^3$ zum Einsatz. Bei dem anderen Prozess (Beispiel 2) wurde auf 24 Stäben abgeschieden in einem Reaktorvolumen von 10 $m^3$.

Beim dritten Prozess (Beispiel 3) betrug das Reaktorvolumen nur 5,9 $m^3$, aber ebenfalls mit 24 Stäben.

Die Stablänge betrug bei allen Prozessen 2,9 bis 3,1 m.

In **Tabelle 3** sind die Parameter der drei Punkte **11, 12** und **13** der in **Fig. 1** dargestellten Kurve **1** aufgeführt.

Die Wandtemperatur $T_{Wand}$ betrug konstant 393 K. Die Querschnittsfläche der Düsen blieb konstant bei 4,185 x $10^{-3}$ $m^2$.

In der zweiten Spalte ist der Füllgrad des Reaktors dargestellt.

Die Stabtemperatur $T_{Stab}$ ging von 1326K bei einem Füllgrad von 0,16% auf 1302K bei einem Füllgrad von 19% zurück.

Q bezeichnet den Volumenstrom des Reaktionsgases (Trichlorsilan und Wasserstoff) unter Betriebsbedingungen in $m^3$/s. Dieser nimmt zunächst zu und bleibt dann konstant.

$Ar_n$ bezeichnet die Archimedeszahl.

In diesem Fall bleibt die Archimedeszahl zwischen einem Füllgrad von 10,76% und einem Füllgrad von 19,06% im

Wesentlichen konstant. Das gilt auch für den Volumenstrom des Reaktionsgases, der konstant bei 0,192 $m^3$/s bleibt.

**Tabelle 3**

| Kurve **1 Fig. 1** | $T_{Wand}$ [K] | FG [%] | $T_{Stab}$ [K] | Q [$m^3$/s] | $A_d$ [$m^2$] | $Ar_n$ |
|---|---|---|---|---|---|---|
| **11** | 393 | 0,16 | 1326 | 0,043 | $4,185 \times 10^{-3}$ | 21749 |
| **12** | 393 | 10,76 | 1302 | 0,192 | $4,185 \times 10^{-3}$ | 1097 |
| **13** | 393 | 19,06 | 1299 | 0,192 | $4,185 \times 10^{-3}$ | 1100 |

In **Tabelle 4** sind die Parameter der drei Punkte **21, 22** und **23** der in **Fig. 1** dargestellten Kurve **2** (Beispiel 2) aufgeführt. Die Wandtemperatur $T_{Wand}$ im Reaktor betrug auch in diesem Fall konstant 393 K. Auch die Querschnittsfläche der Düsen blieb konstant, in diesem Fall bei 2,161 x $10^{-3}$ $m^2$.

Die Stabtemperatur $T_{Stab}$ ging von 1364 K bei einem Füllgrad von 0,106% auf 1306 K bei einem Füllgrad von 17,98% zurück.

In diesem Fall steigt die Archimedeszahl zwischen einem Füllgrad von 5,03% und einem Füllgrad von 17,98% von 1332 auf 2671 an.

**Tabelle 4**

| Kurve **2 Fig. 1** | $T_{Wand}$ [K] | FG [%] | $T_{Stab}$ [K] | Q [$m^3$/s] | $A_d$ [$m^2$] | $Ar_n$ |
|---|---|---|---|---|---|---|
| **21** | 393 | 0,106 | 1364 | 0,027 | $2,161$ x $10^{-3}$ | 18121 |
| **22** | 393 | 5,03 | 1342 | 0,099 | $2,161$ x $10^{-3}$ | 1332 |
| **23** | 393 | 17,98 | 1306 | 0,069 | $2,161 \times 10^{-3}$ | 2671 |

In **Tabelle 5** sind die Parameter von vier Punkten **31, 32, 33** und **34** der in **Fig. 1** dargestellten Kurve **3** (Beispiel 3) aufgeführt. Die Wandtemperatur $T_{Wand}$ im Reaktor betrug auch in diesem Fall konstant 393 K. Auch die Querschnittsfläche der Düsen blieb konstant, in diesem Fall bei 8,18 $\times 10^{-4}$ $m^2$.

Die Stabtemperatur ging von 1299 K bei einem Füllgrad von 0,197% auf 1233 K bei einem Füllgrad von 21,1% zurück.

Bei der Kurve **3** (Beispiel 3) fällt die Archimedes-Zahl zwischen einem Füllgrad von 3,604% und einem Füllgrad von 6,5% stärker ab als für einen Füllgrad von kleiner als 3,604%.

Ab einem Füllgrad von 6,5% ist der Verlauf der Archimedes-Zahl im Wesentlichen konstant. Hier bleibt auch der Volumenstrom des Reaktionsgases konstant bei 0,058 $m^3$/s.

**Tabelle 5**

| Kurve 3 Fig. 1 | Twand [K] | FG [%] | $T_{Stab}$ [K] | Q [m$^3$ / s] | $A_d$ [m$^2$] | $Ar_n$ |
|---|---|---|---|---|---|---|
| **31** | 393 | 0, 197 | 1299 | 0,01 | $8,18 \times 10^{-4}$ | 40599 |
| **32** | 393 | 3,604 | 1272 | 0,031 | $8,18 \times 10^{-4}$ | 4173 |
| **33** | 393 | 6,5 | 1262 | 0,058 | $8,18 \times 10^{-4}$ | 1135 |
| 34 | 393 | 21,1 | 1233 | 0,058 | $8,18 \times 10^{-4}$ | 1120 |

**Patentansprüche**

1. Verfahren zur Herstellung von polykristallinem Silicium, umfassend Einleiten eines Reaktionsgases enthaltend eine Silicium enthaltende Komponente und Wasserstoff mittels einer oder mehreren Düsen in einen Reaktor mit einem Leerraumvolumen, begrenzt durch Wände mit einer bestimmten Temperatur $T_{wand}$, enthaltend wenigstens einen auf eine Temperatur $T_{stab}$ erhitzten Filamentstab, auf dem Silicium abgeschieden wird, **dadurch gekennzeichnet, dass** eine Archimedes-zahl Ar, die strömungsverhaltnisse im Reaktor beschreibt und wie folgt berechnet wird: Ar = n* $\pi$ * g * L$^3$ * $A_d$ * ($T_{stab}$ - $T_{wand}$) / (2 + Q$^2$ * ($T_{stab}$ + $T_{wand}$)), wobei n für die Zahl der Filamentstäbe, g für die Erdbeschleunigung in m/s$^2$, L für die Stablänge der Filamentstäbe in m, Q für einen Volumenstrom des Reaktions-gases in m$^3$/s unter Betriebsbedingungen (p, T), $A_d$ für die Summe aller Düsenquerschnittsflächen in m$^2$, $T_{stab}$ für die Stabtemperatur in K und $T_{wand}$ für die Wandtemperatur in K stehen, in Abhängigkeit vom Füllgrad FG, der das Verhältnis von einem Stabvolumen zu einem Reaktorleerraumvolumen in Prozent angibt, für einen Füllgrad FG von bis zu 5% innerhalb des nach unten durch die Funktion Ar = 2000 x FG$^{-0,6}$ und nach oben durch die Funktion Ar = 17000 x FG$^{-0,9}$ begrenzten Bereichs liegt, und bei einem Füllgrad von größer als 5% in einem Bereich von mindestens 750 bis höchstens 4000 liegt.

2. Verfahren nach Anspruch 1, wobei die Archimedes-Zahl bis zu einem Füllgrad von A, 5-5, 5% abfällt und bei einem höheren Füllgrad konstant bleibt.

3. Verfahren nach Anspruch 1, wobei die Archimedes-Zahl bis zu einem Füllgrad von 6,5-7,5% abfällt und anschließend konstant bleibt, wobei sie ab einem Füllgrad von mehr als 4,5% stärker abfällt als bei einem Füllgrad von 1-3%.

4. Verfahren nach Anspruch 1, wobei die Archimedes-Zahl bis zu einem Füllgrad von 4,5-5,5% abfällt und bei einem höheren Füllgrad ansteigt.

5. Verfahren nach einem der Ansprüche 1 bis 4, wobei das Reaktorvolumen durch eine Wand begrenzt ist, deren Temperatur 300 K bis 700 K beträgt.

6. Verfahren nach einem der Ansprüche 1 bis 4, wobei eine Temperatur, gemessen an einer der Wand des Reaktors gegenüber liegenden Seite des wenigstens einen Stabes und auf halber Höhe einer Länge dieses wenigstens einen Stabes 1150 K bis 1600 K beträgt.

7. Verfahren nach einem der Ansprüche 1 bis 6, wobei der wenigstens eine Stab nach Siliciumabscheidung dem Reaktor entnommen und durch mechanische Bearbeitung zu Siliciumbruchstücken verarbeitet wird.

8. Verfahren nach einem der Ansprüche 1 bis 6, wobei als weiterer Verfahrensschritt das hergestellte polykristalline Silicium zur Erzeugung eines Siliciumeinkristalls durch Zonenschmelzen eingesetzt wird.

9. Verfahren nach einem der Ansprüche 1 bis 7, wobei als weiterer Verfahrensschritt das hergestellte polykristalline Silizium zur Erzeugung eines Siliciumeinkristalls durch Kristallziehen nach dem Czochralskiverfahren eingesetzt wird.

10. Verfahren nach einem der Ansprüche 1 bis 7, wobei als weiterer Verfahrensschritt das hergestellte polykristalline Silicium zur Erzeugung eines Siliciumkristalls durch Blockgießen eingesetzt wird.

**Claims**

1. Process for producing polycrystalline silicon, comprising introduction of a reaction gas comprising a silicon-containing component and hydrogen by means of one or more nozzles into a reactor with an empty volume, bounded by walls with a particular temperature $T_{wall}$ comprising at least one filament rod heated to a temperature $T_{rod}$, on which silicon is deposited, **characterized in that** an Archimedes number Ar, which describes flow conditions in the reactor and is calculated as follows: $Ar = n * \pi * g * L^3 * A_d * (T_{rod} - T_{wall}) / (2 * Q^2 * (T_{rod} + T_{wall}))$ where n is the number of filament rods, g is the acceleration due to gravity in m/s$^2$, L is the rod length of the filament rods in m, Q is a volume flow of the reaction gas in m$^3$/s under operating conditions (p, T), $A_d$ is the sum of all nozzle cross-sectional areas in m$^2$, $T_{rod}$ is the rod temperature in K and $T_{wall}$ is the wall temperature in K, as a function of the fill level FL which states the ratio of one rod volume to one empty reactor volume in percent, for a fill level FL of up to 5% is within the range limited at the lower end by the function $Ar = 2000 \times FL^{-0.6}$ and at the upper end by the function $Ar = 17\,000 \times FL^{-0.9}$, and at a fill level of greater than 5% is within a range from at least 750 to at most 4000.

2. Process according to Claim 1, wherein the Archimedes number declines down to a fill level of 4.5-5.5% and remains constant at a higher fill level.

3. Process according to Claim 1, wherein the Archimedes number declines down to a fill level of 6.5-7.5% and then remains constant, and declines to a greater extent from a fill level of more than 4.5% than at a fill level of 1-3%.

4. Process according to Claim 1, wherein the Archimedes number declines down to a fill level of 4.5-5.5% and rises at a higher fill level.

5. Process according to any of Claims 1 to 4, wherein the reactor volume is bounded by a wall whose temperature is 300 K to 700 K.

6. Process according to any of Claims 1 to 4, wherein a temperature measured on a side of the at least one rod facing the wall of the reactor and at half the height of one length of this at least one rod is 1150 K to 1600 K.

7. Process according to any of Claims 1 to 6, wherein the at least one rod after silicon deposition is removed from the reactor and processed mechanically to give silicon chunks.

8. Process according to any of Claims 1 to 6, wherein as a further process step, the polycrystalline silicon produced is used for production of a single silicon crystal by zone melting.

9. Process according to any of Claims 1 to 7, wherein as a further process step, the polycrystalline silicon produced is used for production of a single silicon crystal by crystal pulling by the Czochralski process.

10. Process according to any of Claims 1 to 7, wherein as a further process step, the polycrystalline silicon produced is used for production of a silicon crystal by block casting.

**Revendications**

1. Procédé de fabrication de silicium polycristallin, comprenant l'introduction d'un gaz réactionnel contenant un composant contenant du silicium et de l'hydrogène par une ou plusieurs buses dans un réacteur ayant un volume d'espace vide, délimité par des parois ayant une température $T_{paroi}$ déterminée, contenant au moins une barre filamentaire chauffée à une température $T_{barre}$ sur laquelle du silicium est déposé, **caractérisé en ce qu'**un nombre d'Archimède Ar, qui décrit les conditions d'écoulement dans le réacteur et est calculé de la manière suivante : $Ar = n * \Pi * g * L^3 * A_d * (T_{barre} - T_{paroi}) / (2 * Q^2 * (T_{barre} + T_{paroi}))$, n représentant le nombre de barres filamentaires, g représentant l'accélération de la pesanteur en m/s$^2$, L représentant la longueur des barres filamentaires en m, Q représentant un débit volumique du gaz réactionnel en m$^3$/s dans les conditions d'exploitation (p, T), $A_d$ représentant la somme de toutes les sections des buses en m$^2$, $T_{barre}$ représentant la température des barres en K et $T_{paroi}$ représentant la température des parois en K, se situe, en fonction du degré de remplissage FG, qui donne le rapport entre un volume des barres et un volume de l'espace vide du réacteur en pourcentage, pour un degré de remplissage FG de jusqu'à 5 %, dans la plage délimitée par le bas par la fonction $Ar = 2\,000 \times FG^{-0,6}$ et par le haut par la fonction $Ar = 17\,000 \times FG^{-0,9}$, et, à un degré de remplissage supérieur à 5 %, dans une plage d'au moins 750 à au plus 4 000.

**2.** Procédé selon la revendication 1, dans lequel le nombre d'Archimède diminue jusqu'à un degré de remplissage de 4,5 à 5,5 % et reste constant à un degré de remplissage supérieur.

**3.** Procédé selon la revendication 1, dans lequel le nombre d'Archimède diminue jusqu'à un degré de remplissage de 6,5 à 7,5 %, puis reste constant, ledit nombre d'Archimède diminuant plus fortement à partir d'un degré de remplissage supérieur à 4,5 % qu'à un degré de remplissage de 1 à 3 %.

**4.** Procédé selon la revendication 1, dans lequel le nombre d'Archimède diminue jusqu'à un degré de remplissage de 4,5 à 5,5 % et augmente à un degré de remplissage supérieur.

**5.** Procédé selon l'une quelconque des revendications 1 à 4, dans lequel le volume du réacteur est délimité par une paroi dont la température est de 300 K à 700 K.

**6.** Procédé selon l'une quelconque des revendications 1 à 4, dans lequel une température mesurée sur un côté de la ou des barres en regard de la paroi du réacteur et à mi-hauteur d'une longueur de cette ou ces barres est de 1 150 K à 1 600 K.

**7.** Procédé selon l'une quelconque des revendications 1 à 6, dans lequel la ou les barres sont sorties du réacteur après le dépôt de silicium et transformées par traitement mécanique en fragments de silicium.

**8.** Procédé selon l'une quelconque des revendications 1 à 6, dans lequel le silicium polycristallin fabriqué est utilisé pour la formation d'un monocristal de silicium par fusion de zone en tant qu'étape de procédé supplémentaire.

**9.** Procédé selon l'une quelconque des revendications 1 à 7, dans lequel le silicium polycristallin fabriqué est utilisé pour la formation d'un monocristal de silicium par tirage du cristal selon le procédé de Czochralski en tant qu'étape de procédé supplémentaire.

**10.** Procédé selon l'une quelconque des revendications 1 à 7, dans lequel le silicium polycristallin fabriqué est utilisé pour la formation d'un cristal de silicium par coulée en lingotière en tant qu'étape de procédé supplémentaire.

Fig. 1

Legend: MAX, MIN, Beispiel 1, Beispiel2, Beispiel3, Vergleichsbeispiel

Axes: $Ar_n$ (100, 1000, 10000, 100000); Füllgrad (0,1% — 1,0% — 10,0% — 100,0%)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 2077252 A2
- DE 2912661 A1
- EP 2067744 A2
- DE 102007047210 A1
- DE 102007023041 A1

### In der Beschreibung aufgeführte Nicht-Patentliteratur

- Repetitorium der technischen Thermodydnamik. **DITTMANN ; FISCHER ; HUHN ; KLINGER.** Repetitorium der technischen Thermodydnamik. Teubner Verlag, 1995